# EUROPEAN PATENT APPLICATION

(11) **EP 2 161 975 A2**
(43) Date of publication of application: **10.03.2010**
(21) Application number: 09252130.1
(22) Date of filing: 03.09.2009
(51) Int. Cl.: H05K 3/30, H01R 33/02

(54) **Connection structure of circuit board and connecting device**

(30) Priority: 03.09.2008 JP 2008225983
(71) Applicant: Hosiden Corporation, Yao-shi, Osaka 581-0071 (JP)
(72) Inventor: Ohmori, Yasuhiro, Yao-shi Osaka 581-0071 (JP); Nakamura, Masahiko, Yao-shi Osaka 581-0071 (JP)
(74) Representative: Beresford, Keith Denis Lewis

(57) **Abstract**

An inexpensive connection structure of a circuit board and a connecting device is disclosed that allows easy connection/detachment of the connecting device to/from the circuit board. The connection structure includes a connecting device 100 electrically and mechanically connectable to a longitudinal end of a cold cathode fluorescent lamp 10 via an adapter 400, and a circuit board 300 electrically and mechanically connected with the connecting device 100. The connecting device 100 includes a locking piece 114. The circuit board 300 has a locking hole 310 for locking the locking piece 114. The locking hole 310 is a slot consisting of a wider hole 311 and a narrower hole 312 continuous with the wider hole 311. The locking piece 114 can be locked at a lip 312a of the narrower hole 312 by inserting the locking piece 114 into the wider hole 311 and sliding it from the wider hole 311 to the narrower hole 312.

## Description

The present invention relates to connection structures for providing connection between connecting devices connectable to ends of electronic components, e.g., cold cathode fluorescent lamps or hot cathode fluorescent lamps, and circuit boards to mount the connecting devices thereon.

A known structure for connecting a plurality of connecting devices to a circuit board which is configured such that the connecting devices are fitted in openings in a frame to be installed on the circuit board is described in Japanese Unexamined Patent Publication No. 2006-344602. The connecting devices fitted in the openings are aligned in a direction orthogonal to a longitudinal direction of cold cathode fluorescent lamps. In this state, the frame is fixed to the circuit board by using a plurality of clips, so that the connecting devices are kept connected to the circuit board.

The above known structure requires a plurality of clips to fix a frame to a circuit board and to keep connecting devices in stable electrical connection with the circuit board.

It is however a time-consuming task to attach the clips to the end of the frame and to the ends of the circuit board. It is also time consuming to detach the clips from the frame and the circuit board for maintenance work. In addition, the need of using the clips means increase in the number of components, resulting in increased costs.

The present invention was made in view of the foregoing circumstances. An embodiment of the invention provides a connection structure of a circuit board and a connecting device in reduced costs, allowing easy connection/detachment of the connecting device to/from the circuit board.

A connection structure of a circuit board and a connecting device of the present invention includes: a connecting device electrically and mechanically connectable to an electronic component; and a circuit board having a surface to mount the connecting device thereon. The connecting device has a locking piece for attaching the connecting device to the surface of the circuit board. The circuit board has an elongated locking hole for receiving the locking piece. The locking piece is adapted to be locked at a lip of the locking hole by sliding or turning the locking piece in a predetermined direction inside the locking hole.

In such a connection structure of a circuit board and a connecting device, the locking piece is locked at the lip of the locking hole simply by inserting the locking piece into the locking hole and sliding or turning the locking piece in the predetermined direction. The connecting device can therefore be attached to the circuit board easily without using clips as in the conventional example, facilitating assembly. The elimination of the clips also leads to a reduced number of components. Hence, the connection structure can be assembled at a reduced cost in comparison with the conventional example. Further, the connection structure is also advantageous in ease of maintenance. Particularly, the locking piece can be released from the locked state with the lip of the locking hole, simply by sliding or turning the locking piece in the opposite direction to the predetermined direction inside the locking hole. The connecting device can be thus detached from the circuit board easily without the need to remove a plurality of clips.

The locking piece may be provided not on the connecting device but on the circuit board, and the locking hole may be provided not in the circuit board but in the connecting device. This configuration also produces a similar effect to that of the above connection structure of a circuit board and a connecting device.

The locking hole may have a wider hole and a narrower hole continuous with the wider hole. In this case, the locking piece can be locked at the lip of the locking hole by inserting the locking piece into the wider hole and sliding the locking piece from the wider hole to the narrower hole.

In this case, the connecting device can be attached to the circuit board by inserting the locking piece into the wider hole and sliding the locking piece from the wider hole to the narrower hole to lock the locking piece at the lip of the narrower hole. Accordingly, the attachment of the connecting device to the circuit board does not require a plurality of clips as in the conventional example, facilitating the assembly work. The detachment of the connecting device from the circuit board is also easy, simply moving the locking piece from the narrower hole to the wider hole and taking the locking piece out of the wider hole.

The connection structure may further include an adapter interposed between the electronic component and the connecting device. The adapter may include a first end portion, electrically and mechanically connectable to an end of the electronic component; a second end portion, electrically and mechanically connectable to the connecting device; and an elastically deformable portion, provided between the first and second ends and elastically deformable at least in the longitudinal direction of the electronic component.

In such a connection structure, even if the electronic component thermally expands or contracts in the state where its end is connected to a first end of the adapter and a second end of the adapter is connected to a connecting device, the elastically deformable portion of the adapter expands or contracts in response to thermal expansion or contraction of the electronic component. The electronic component thus thermally expands or contracts with its ends kept mechanically connected, thereby reducing a load imposed on the ends of the electronic component.

The elastically deformable portion may be configured to absorb impact on the electronic component while the connecting device is being attached to or detached from the circuit board with the electronic component connected to the connecting device via the adapter. In this case, elastic deformation of the elastically deformable portion absorbs impact on the ends of the electronic component due to shakes of the electronic component during the attachment/detachment of the connecting device to/from the circuit board with the electronic component connected with the connecting device via the adapter. Thus, the connecting device can be attached to and /detached from the circuit board with further ease, in a state where the electronic component is connected to the connecting device via the adapter. Further ease of maintenance is thus achieved in this respect.

The connecting device may include a body provided with the locking piece or the locking hole; and a contact to fit in the body, the contact having a contacting portion projecting from the body toward the circuit board. The connection structure may be configured such that the contacting portion touches a contact conductor on the surface of the circuit board when the locking piece is brought into engagement with the lip of the locking hole.

In this case, just by sliding or turning the locking piece in the locking hole to lock the locking piece at the lip of the locking hole, the contacting portion of the contact touches the contact conductor on the circuit board to establish electrical connection. That is, mechanical and electrical connections are established simultaneously between the connecting device and the circuit board, which achieves easy connection of the connecting device to the circuit board.

In the case where the connection structure includes a plurality of connecting devices that are aligned and held on the surface of the circuit board, the connection structure may further include a locating and holding means for locating and holding the connecting devices in attachment to and detachment from the circuit board, in such a manner as to correspond to an arrangement of the connecting devices on the circuit board.

Such locating and holding means enables all the connecting devices to be attached to the circuit board at a stroke. More particularly, with the locating and holding means holding the connecting devices, the locking pieces are inserted into the locking holes and then slid or turned in the predetermined direction. This configuration further facilitates assembly, leading to cost reduction. Moreover, all the connecting devices can be detached from the circuit board at a stroke. More particularly, with the locating and holding means holding the connecting devices, the locking pieces are slid or turned in the opposite direction to the predetermined direction. Further ease of maintenance is thus achieved.

The connection structure may include a first set of connecting devices that are electrically and mechanically connectable to respective first ends in a longitudinal direction of a plurality of electronic components and a second set of connecting devices that are electrically and mechanically connectable to respective second ends in the longitudinal direction of the electronic components. In this case, the locating and holding means may locate and hold the first and second sets of connecting devices to be aligned in a direction orthogonal to the longitudinal direction.

In such a connection structure of a circuit board and a connecting device, all the connecting devices can be attached to the circuit board at a stroke. More particularly, with the locating and holding means holding the first and second sets of connecting devices in alignment, the locking pieces are inserted into the locking holes and then slid or turned in the predetermined direction. This aspect of invention further facilitates assembly and reduces costs. Further ease of maintenance is also achieved because all the connecting devices can be detached from the circuit board at a stroke. More particularly, with the locating and holding means holding the first and second sets of connecting devices in alignment, the locking pieces are slid or turned in the opposite direction from the predetermined direction and then taken out. Moreover, the locating and holding means holds the first and second sets of connecting devices. Thus, the first and second sets of connecting devices will not be moved in different directions during the attachment/detachment of the connecting devices to/from the circuit board, and the connecting devices can be easily attached to or detached from the circuit board with electronic components connected to the connecting devices. As such, ease of maintenance is achieved also in this respect.

The locating and holding means may be an elongated member that faces the circuit board and may have locating holes to receive the connecting devices. The connecting devices may each further include a retaining part for preventing the connecting device from falling off from the associated locating hole in the locating and holding means.

In this case, it is easy to locate the connecting devices because the connecting devices are held in place just by inserting the connecting devices into the locating holes. Further, the retaining parts prevent the connecting devices from becoming detached from the locating holes in the locating and holding means.

The retaining parts may each include a flange and a locking formation. Each flange may project from an outer surface of each connecting device, each locking formation may be provided on the outer surface of the connecting device, and the flange and the locking formation may be spaced apart from each other in an insertion direction of the connecting device. The connection structure may be configured such that, upon insertion of each connecting device into the associated locating hole, the lip of the locating hole in the locating and holding means passes or climbs over the locking formation and is locked between the locking formation and the flange.

When the connecting devices are inserted into the locating holes in the locating and holding means from the side of the locking formations, the lips of the locating holes pass or climb over the locking formations to be locked between the flanges and the locking formations. Thus, the connecting devices are easily attached to the locating and holding means. It is also easy to detach the connecting devices from the locating and holding means. More particularly, when the locating and holding means is moved, in relation to the connecting devices, to the side of the locking formations, the lips of the locating holes pass or climb over the locking formations and then are released from the engagement between the flange and the locking formations, so that the connecting devices can be taken out.

The locking formations may be in the form of locking projections. The two ends of each locking projection may be tapered such that a thickness of the locking projection gradually reduces in directions away from each other. The locking projections with such tapered ends allow the lips of the locating holes to pass or climb over the locking projections even more easily. Hence, the attachment and detachment of the connecting devices to/from the locating and holding means is further facilitated.

The connecting devices may alternatively each have a locking formation in the form of a locking arm in place of the locking projection. In this case, the proximal end of the locking arm may be connected to the outer surface of the connecting device and the leading end of the locking arm may face the flange with a gap therebetween. Each locking arm may be configured such that a distance between the leading end and the outer surface of the connecting device is greater than a distance between the proximal end and the outer surface of the connecting device. When each connecting device is inserted in the associated locating hole, the associated locking arm may be pressed against the lip of the locating hole and is elastically deformed toward the outer surface. When the lip of the locating hole moves over the leading end of the locking arm, the locking arm may be restored and the lip of the locating hole may thereby be locked between the leading end of the locking arm and the flange.

In this case also, when each connecting device is inserted into the associated locating hole in the locating and holding means from the side of the locking arm, the lip of the locating hole can move over the leading end of the locking arm and is locked between the leading end of the locking arm and the flange. Thus, the connecting device is easily attached to the locating and holding means. It is also easy to detach each connecting device from the locating and holding means. More particularly, by pressing the locking arm toward the outer surface of the connecting device into elastic deformation, the lip of the locating hole is released from the locked state with the leading end of the locking arm. In this state, the locating and holding means can be moved, in relation to the connecting device, to the side of the locking arm and can be taken out.

In the case where the electronic components are illumination lights, the locating and holding means may also function as a reflector board for reflecting light flux emitted from the illumination lights. The locating and holding means doubling as a reflector board contributes to a simplified structure of the illumination unit.

The invention will now be described by way of example only and without limitation with reference to the drawings, in which:
Figs. 1A and 1B are schematic diagrams showing a connection structure of a circuit board and a connecting device according to an embodiment of the present invention, where Fig. 1A is a front view and Fig. 1B is a cross-sectional view taken along line 1(B)-1(B).
Fig. 2 is a schematic perspective view at a first end side of the connection structure.
Fig. 3 is a schematic perspective exploded view of the α portion in Fig. 2 of the connection structure.
Figs. 4A to 4F are schematic diagrams showing a connecting device of the connection structure, where Fig. 4A is a front view, Fig. 4B is a plan view, Fig. 4C is a bottom view, Fig. 4D is a side view, Fig. 4E is a perspective view, and Fig. 4F is a cross-sectional view taken along line 4(F)-4(F).
Figs. 5A to 5E are schematic diagrams showing a body of the connecting device of the connection structure, where Fig. 5A is a front view, Fig. 5B is a plan view, Fig. 5C is a bottom view, Fig. 5D is a side view, and Fig. 5E is a perspective view.
Figs. 6A and 6B are schematic diagrams showing a contact of the connecting device of the connection structure, where Fig. 6A is a perspective view as viewed from a front upper right side and Fig. 6B is a perspective view as viewed from a rear upper left side.
Figs. 7A and 7B are schematic diagrams showing an adapter of the connection structure, where Fig. 7A is a perspective view as viewed from a front upper right side and Fig. 7B is a perspective view as viewed from a rear upper left side.
Figs. 8A and 8B are schematic diagrams showing the connection structure with locking pieces of a connecting device lockingly engaged at lips of locking holes in the circuit board, where Fig. 8A is a perspective view with the frame removed as viewed from an upper side and Fig. 8B is a perspective view as viewed from a lower side.
Figs. 9A to 9C are schematic diagrams showing a modification of the connecting device of the connection structure, where Fig. 9A is a perspective view as viewed from a rear upper left side, Fig. 9B is a perspective view as viewed from a front upper right side, and Fig. 9C is a cross-sectional view taken along line C-C, showing a state in which the connecting device is attached to a frame.
Figs. 10A to 10C are schematic diagrams showing a modified adapter of the connection structure, where Fig. 10A is a front view showing the adapter connected to an end of a cold cathode fluorescent lamp, Fig. 10B is a side view of the adapter connected to the end of the cold cathode fluorescent lamp, and Fig. 10C is a perspective view.
Figs. 11A to 11C are schematic diagrams showing another modified adapter of the connection structure, where Fig. 11A is a front view of the adapter connected to an end of a hot cathode fluorescent lamp, Fig. 11B is a plan view of the adapter connected to the end of the hot cathode fluorescent lamp, and Fig. 11C is a side view of the adapter connected to the end of the hot cathode fluorescent lamp.

In the description which follows, relative spatial terms such as "upper", "lower", "upward", "downward", "bottom", "above", "below", "front", "rear", "left", "right", etc., are used for the convenience of the skilled reader and refer to the orientation of the connection structure and its constituent parts as depicted in the drawings. No limitation is intended by use of these terms, either in use of the invention, during its manufacture, shipment, custody, or sale, or during assembly of its constituent parts or when incorporated into or combined with other apparatus.

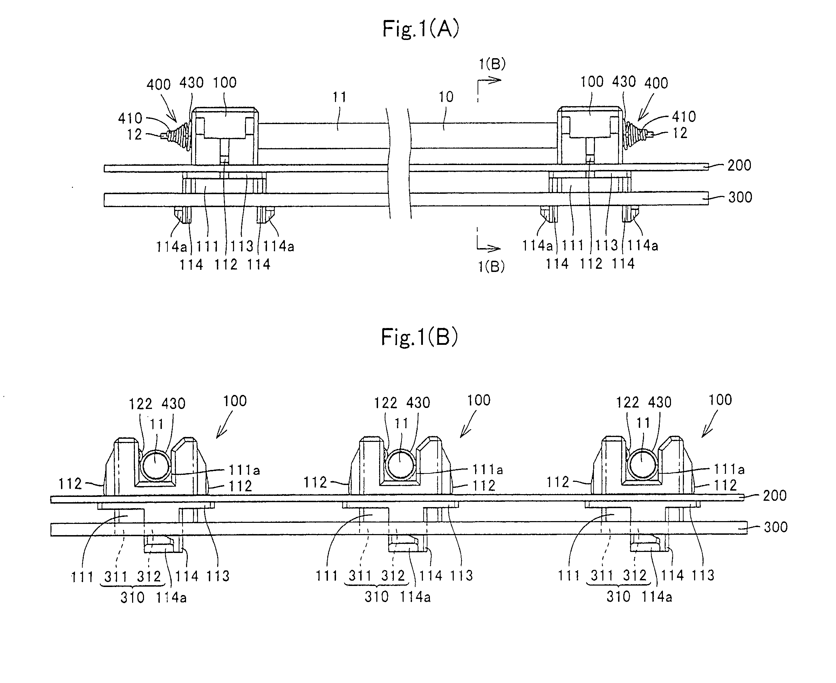

A connection structure of a circuit board and a connecting device according to an embodiment of the present invention is described below with reference to Figs. 1A to 8B.

The connection structure shown in Figs. 1A to 2 includes a plurality of connecting devices 100, a frame 200 (a locating and holding means), a circuit board 300, and a plurality of adapters 400. The connecting devices 100 are sockets that are connectable to respective longitudinal first and second ends of cold cathode fluorescent lamps 10 (electronic components). The frame 200 locates and holds each of the connecting devices 100. The circuit board 300 is mounted with the connecting devices 100. The adapters 400 are interposed between the cold cathode fluorescent lamps 10 and the connecting devices 100. These components are described in detail below.

As shown in Figs. 1A to 3, the cold cathode fluorescent lamps 10 each have an elongated columnar lamp portion 11 and first and second lead terminals 12 that project from longitudinal first and second ends, respectively, of the lamp portion 11.

The adapters 400 are coil springs fabricated by winding conductive wires. As shown in Figs. 1A to 3 and 7A and 7B, the adapters 400 each have a first connecting portion 410 (a first end portion) in the form of an end turn with the smallest diameter, a second connecting portion 420 (a second end portion) in the form of an end turn with the largest diameter, and an elastically deformable portion 430 of conical shape provided between the first and second connecting portions 410 and 420.

The first connecting portions 410 have an inner diameter that is slightly larger than the outer diameter of either lead terminal 12 of the cold cathode fluorescent lamps 10, so that the first connecting portions 410 can receive the leading ends of the lead terminals 12 of the cold cathode fluorescent lamps 10. The first connecting portions 410 are electrically and mechanically connected to the leading ends of the lead terminals 12 received in them by soldering or welding.

The second connecting portions 420 have an inner diameter that is slightly larger than the diameter of the lamp portions 11 of the cold cathode fluorescent lamps 10. Accordingly, the second connecting portions 420 can receive the longitudinal ends of the lamp portions 11.

The elastically deformable portions 430 are conical coils that are elastically deformable in the longitudinal direction of the cold cathode fluorescent lamps 10. The elastically deformable portions 430 receive the rear ends of the lead terminals 12 therethrough when the first connecting portions 410 receive the leading ends of the lead terminals 12.

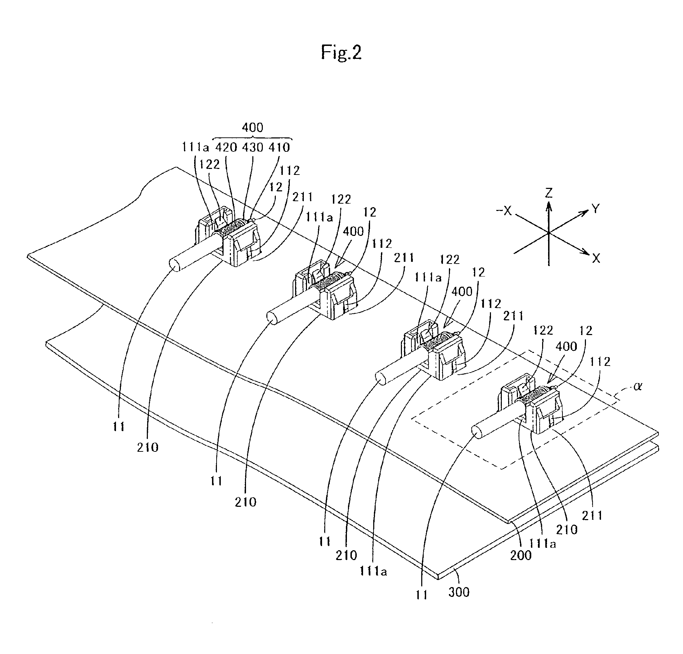

The frame 200 is a frame of a backlight unit including the cold cathode fluorescent lamps 10. The frame 200 is an elongated plate of a metal, a synthetic resin or other material. The upper surface of the frame 200 serves as a reflective surface that reflects light flux emitted from the cold cathode fluorescent lamps 10. The frame 200 has a plurality of locating holes 210 that are spaced apart from one another in the X direction (i.e., a direction orthogonal to the longitudinal direction of the cold cathode fluorescent lamps 10), along opposite end portions in the Y direction (i.e., the longitudinal direction of the cold cathode fluorescent lamps 10) of the frame 200. For the purpose of illustration, Fig. 2 only shows the locating holes 210 along one of the end portions in the Y direction of the frame 200.

The locating holes 210 are through-holes of generally rectangular shape conforming to the contours of bodies 110 of the connecting devices 100. When the connecting devices 100 are inserted into the locating holes 210, the connecting devices 100 are located and held, being aligned on the first and second end sides in the Y direction of the frame 200.

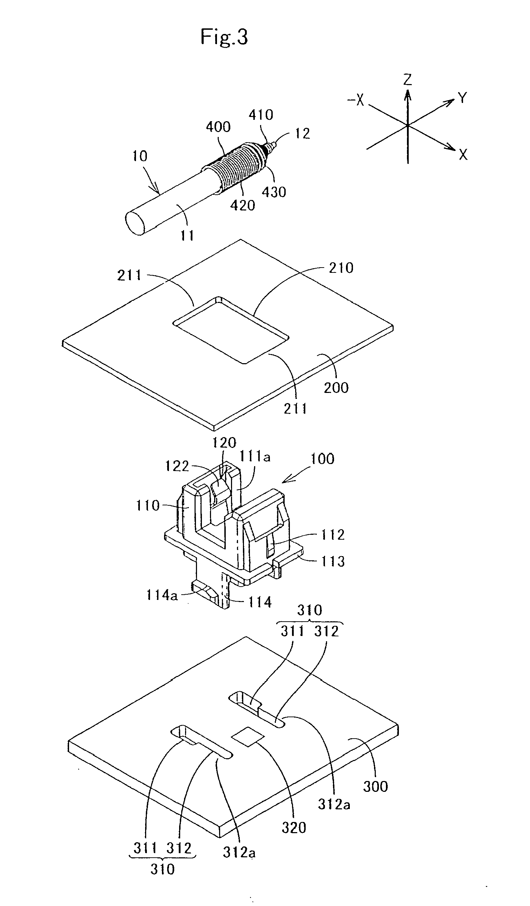

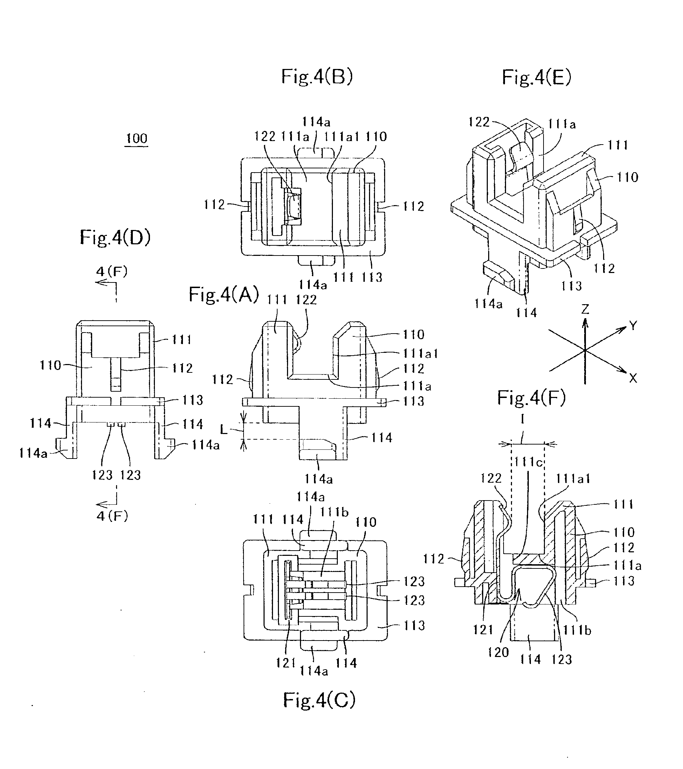

As shown in Figs. 3 and 4A-F, the connecting devices 100 each have the body 110 and a contact 120 fitted inside the body 110.

The bodies 110 are injection molded articles of insulative plastics material. As shown in Figs. 2 to 5A-E, the bodies 110 each have a main portion 111 of generally rectangular parallelepiped shape.

An adapter receiving recess 111a is provided at the upper portion of each main portion 111 to receive the second connecting portion 420 of each adapter 400.

Each main portion 111 has a pair of locking projections 112, formed on opposite outer faces (outer surfaces of each body 110) in the X direction of the upper portion of the main portion 111. The width dimension of each main portion 111, including the locking projections 112, is slightly greater than each length dimension of the locating holes 210 in the frame 200. Because of this structure, upon insertion of a main portion 111 into a locating hole 210 in the frame 200, lips 211 of the locating hole 210 in the frame 200 can pass or climb over the locking projections 112.

It should be noted that each locking projection 112 has upper and lower tapered ends, i.e. the thickness of the locking projection gradually reduces in directions away from each other. These tapered ends make it easier for lips 211 of the locating holes 210 in the frame 200 to climb over the locking projections 112.

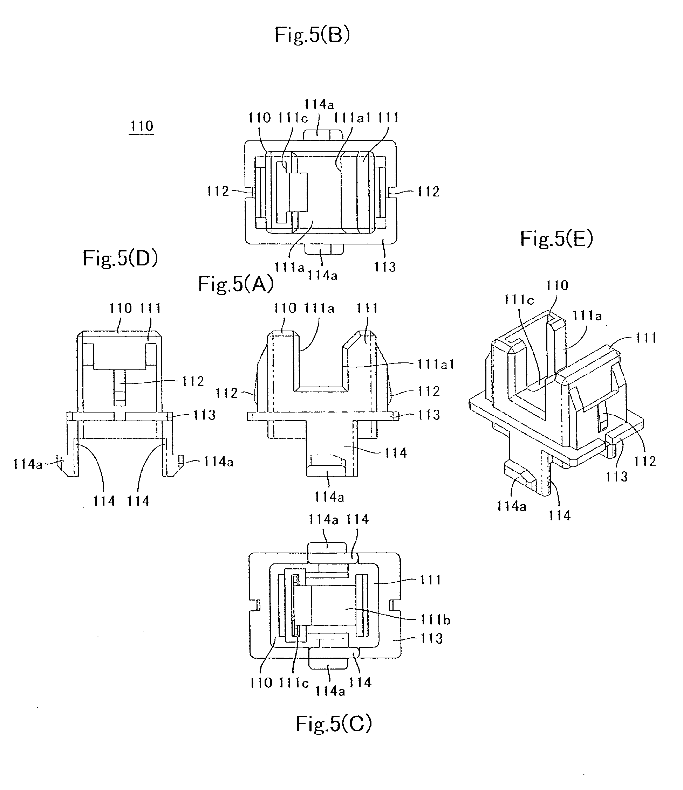

As shown in Figs. 4A-F and 5A-E, each main portion 111 has a flange 113 looping around its outer surfaces. The flange 113 is located intermediate the height of the main portion 111, below the locking projections 112. The flange 113 is separated from either locking projection 112 by a distance that is substantially equal to the thickness dimension of the frame 200. Accordingly, the lips 211 of the locating holes 210 in the frame 200, when having passed or climbed over the locking projections 112, are held between the locking projections 112 and the flange 113. That is, the locking projections 112 and the flange 113 constitute a retaining part that prevents the connecting devices from falling from the locating holes 210 in the frame 200.

A contact receiving hole 111b is formed in the lower end of each main portion 111 for securing a press-fitting plate 121 and contacting portions 123 of each contact 120. The bottom of each contact receiving hole 111b is further recessed in part as a lead-out hole 111c communicating with the adapter receiving recess 111a. A clamp piece 122 of each contact 120 is led out through the lead-out hole 111c into the adapter receiving recess 111a.

As shown in Figs. 4A to 5E, flat-shaped paired locking pieces 114 extend downward from opposite lower ends in the Y direction of each main portion 111. The upper ends of the locking pieces 114 continue to respective ends in the Y direction of the flange 113, while lower ends of the locking pieces 114 have hooks 114a on their outer surfaces. As shown in Fig. 4A, the hooks 114a and the lower endface of the main portion 111 are separated by a height difference L that is substantially equal to the thickness of the circuit board 300. Because of this structure, when the locking hooks 114a are locked at lips 312a of locking holes 310 (to be described later) in the circuit board 300, the circuit board 300 is locked between the main portion 111 and the locking hooks 114a. Each hook 114a has a tapered upper endface at the end thereof in the X direction, such that the hooks 114a will not be caught against the lips 312a of narrower holes 312 when the hooks 114a are being moved from wider holes 311 to the narrow holes 312 of the locking holes 310 in the circuit board 300.

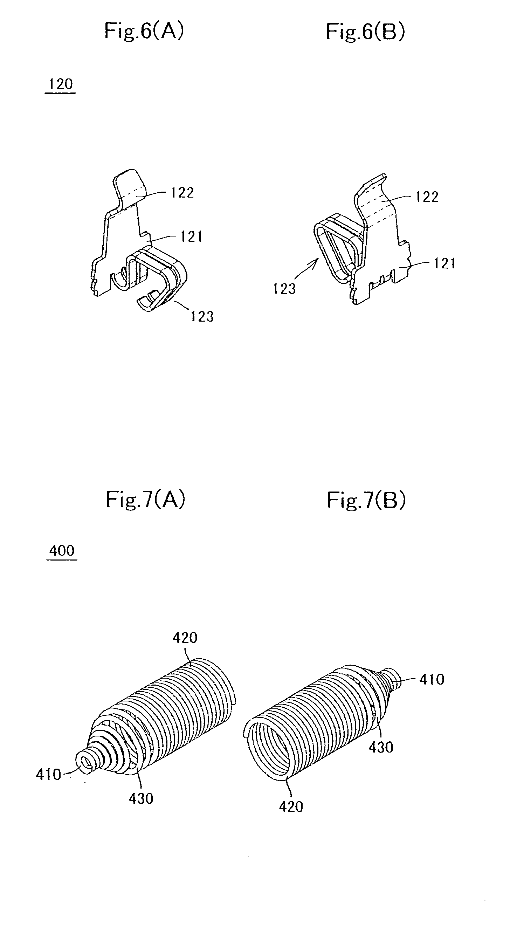

The contacts 120 are made by press forming from an electrically conductive metal plate. As shown in Figs. 6A and 6B, the contacts 120 each have the generally rectangular press-fitting plate 121, the clamp piece 122 continuous from the upper end of the press-fitting plate 121, and the contacting portions 123 continuous from the lower end of the press-fitting plate 121.

Each press-fitting plate 121 has paired lugs at its opposite ends. The width dimension of the press-fitting plate 121 including the lugs is slightly greater than the distance between two inner wall surfaces facing in the Y direction of each contact receiving hole 111b. The contact receiving hole 111b can thus fittingly receive and hold the press-fitting plate 121 as shown in Figs. 4C and 4F.

The clamp pieces 122 are each an elastically deformable, plate-like body with its leading end bent substantially in a V-shape. As shown in Figs. 2 to 4F, the leading end of each clamp piece 122 is inserted into the adapter receiving recess 111a through the lead-out hole 111c in each body 110 to oppose a wall surface 111a1 facing in the Y direction of the adapter receiving recess 111a. The bent portion of the leading end of each clamp piece 122 is separated from the wall surface 111a1 of the adapter receiving recess 111a by a distance I that is slightly shorter than the diameter of the second connecting portion 420 of each adapter 400. Upon insertion of the second connecting portion 420 in between the leading end of the clamp piece 122 and the wall surface 111a1 of the adapter receiving recess 111a, the clamp piece 122 is elastically deformed, so that the second connecting portion 420 of the adapter 400 is securely held between the leading end of the clamp piece 122 and the wall surface 111a1 of the adapter receiving recess 111a.

The contacting portions 123 are a pair of elastically deformable, meandering arms. As shown in Figs. 4D and 4F, the leading ends of the contacting portions 123 project downward from the contact receiving hole 111b in each body 110 such that the leading ends are elastically connectable with contact conductors 320 (to be described later) on the circuit board 300.

The circuit board 300 is a well-known printed circuit board. On opposite end portions in the Y direction of the circuit board 300, a plurality of pairs of locking holes 310 are opened in spaced and aligned relationship in the X direction. Each pair of the locking holes 310 securely receives paired locking pieces 114 of each connecting devices 100

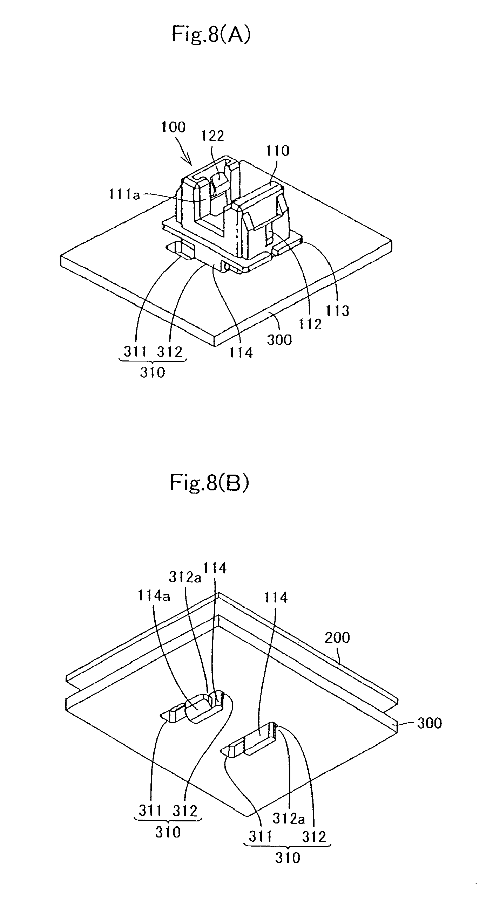

More particularly, as shown in Figs. 3, 8A, and 8B, the locking holes 310 are long holes oriented in the X direction. The locking holes 310 each consists of the wider hole 311 in a generally rectangular shape and the narrower hole 312 in a generally rectangular shape communicating with the wider hole 311.

Each wider hole 311 has a slightly greater width dimension than the combined thickness dimension of the lower end and hook 114a of each locking piece 114. Thus, the wider holes 311 can receive the locking pieces 114 therein.

The width dimension of each narrower hole 312 is slightly greater than the thickness dimension of an intermediate portion of each locking piece 114 but is smaller than the combined thickness dimension of the lower end and hook 114a of each locking piece 114. Accordingly, when inserting the locking pieces 114 into the wider holes 311 and sliding the locking pieces 114 from the wider holes 311 to the narrower holes 312, the hooks 114a of the locking pieces 114 become lockingly engaged with the lips 312a of the narrower holes 312 as shown in Figs. 1A, 1B, and 8B.

As shown in Fig. 3, the contact conductors 320 are formed on the circuit board 300, each between the narrower holes 312 of each pair of locking holes 310. Each contact conductor 320 is contacted by the contacting portions 123 of the contact 120 of each connecting device 100 with the locking pieces 114 locked at the lips 312a of the narrower holes 312.

A description is given below of steps for attaching the above-described connecting devices 100 to the frame 200.

First, the body 110 of one of the connecting devices 100 is inserted from below into the locating hole 210 in the frame 200. Then, the lips 211 of the locating hole 210 in the frame 200 slide over the locking projections 112 on the body 110 and abut on the flange 113. As a result, the lips 211 of the locating hole 210 in the frame 200 are held between the locking projections 112 and the flange 113 of the body 110. This procedure is repeated until each of the plurality of connecting devices 100 are all mounted along the opposite end portions in the Y direction of the frame 200. In this manner, the plurality of connecting devices 100 is located and held in alignment along the respective end portions of the frame 200.

A description is given below of steps for connecting the connecting devices 100, attached on the end portions in the Y direction of the frame 200, to opposite end portions in the Y direction of the circuit board 300.

First, with the frame 200 being gripped, the pairs of locking pieces 114 of the connecting devices 100 attached to the end portions of the frame 200 are brought to above the wider holes 311 of the pairs of locking holes 310 in the opposite end portions of the circuit board 300 and inserted into the wider holes 311. Then, the lower ends of the main portions 111 of the connecting devices 100 abut on a surface of the circuit board 300, meanwhile the contacting portions 123 of the contacts 120 of the connecting devices 100 elastically touch the surface of the circuit board 300.

After that, the frame 200 is moved in the X direction. The pairs of locking pieces 114 of the connecting devices 100 then slide from the wider holes 311 to the narrower holes 312 of the pairs of locking holes 310, so that the hooks 114a of the locking pieces 114 are lockingly engaged with the respective lips 312a of the narrower holes 312. The circuit board 300 is now locked between the locking hooks 114a and the main portions 111.

At this point, the contacting portions 123 of the contacts 120 of the connecting devices 100 elastically touch the corresponding contact conductors 320 on the circuit board 300. The connecting devices 100 are thus electrically and mechanically connected, all at a stroke, along the opposite ends of the circuit board 300.

Alternatively, it is possible to first connect the connecting devices 100 to the end portions in the Y direction of the circuit board 300 and then to attach the connecting devices 100 connected to the circuit board 300 to the frame 200.

The description moves on to steps for connecting the adapters 400 electrically and mechanically to the both ends of the cold cathode fluorescent lamps 10.

First, in each of the cold cathode fluorescent lamps 10, its first lead terminal 12 is inserted into the first connecting portion 410 of an adapter 400 through the second connecting portion 420 and the elastically deformable portion 430. Then, the first end of the lamp portion 11 of the cold cathode fluorescent lamp 10 is received in the second connecting portion 420 of the adapter 400.

In this state, the lead terminal 12 of the cold cathode fluorescent lamp 10 is connected to the first connecting portion 410 of the adapter 400 by soldering or welding.

After that, the second lead terminal 12 of the cold cathode fluorescent lamp 10 is inserted into another adapter 400 in the same manner as described above, so as to be connected to the first connecting portion 410 of the adapter 400.

A description is given below of steps for connecting the adapters 400, which are electrically and mechanically connected to the both ends of the cold cathode fluorescent lamps 10, to the connecting devices 100 that are connected to the end portions in the Y direction of the circuit board 300.

First, for each of the adapters 400 connected to either end of a cold cathode fluorescent lamp 10, the second connecting portion 420 is inserted from above into an adapter receiving recess 111a of a respective connecting device 100 that is connected to either end in the Y direction of the circuit board 300.

Then, the second connecting portion 420 of the adapter 400 presses the leading end of the clamp piece 122 of the contact 120 of the connecting device 100. The pressed clamp piece 122 is elastically deformed in a direction away from the wall surface 111a1 of the adapter receiving recess 111a.

After that, the second connecting portion 420 of the adapter 400 passes or climbs over the leading end of the clamp piece 122, whereupon the clamp piece 122 is restored to the original position. As a result, the second connecting portion 420 of the adapter 400 is held between the leading end of the clamp piece 122 and the wall surface 111a1 of the adapter containing recess 111a of the connecting devices 100.

The above steps are repeated for all the adapters until all the opposite ends of the cold cathode fluorescent lamps 10 are electrically and mechanically connected to the connecting devices 100 via the adapters 400.

A description is given below of the operation of the adapters 400 when the cold cathode fluorescent lamps 10 become thermally expanded or contracted due to changes in ambient temperature. The ends of the cold cathode fluorescent lamps 10 are electrically and mechanically connected to the connecting devices 100 via the adapters 400.

Thermal expansion of a cold cathode fluorescent lamp 10 causes its lead terminals 12 and the first connecting portions 410 of the adapters 400 connected to the lead terminals 12 to move along a longitudinal direction of the cold cathode fluorescent lamp 10. At this point, the elastically deformable portions 430 expand in the longitudinal direction because the second connecting portions 420 of the adapters 400 are securely held between the clamp pieces 122 and the wall surfaces 111a1 of the adapter containing recesses 111a of the connecting devices 100. This expansion of the elastically deformable portions 430 reduces the load applied to the lead terminals 12 and to the portions proximal to the lead terminals 12 of the lamp portions 11 during thermal expansion of the cold cathode fluorescent lamp 10.

On the other hand, thermal contraction of a cold cathode fluorescent lamp 10 causes its lead terminals 12 and the first connecting portions 410 of the adapters 400 connected to the lead terminals 12 to move along the opposite direction to the directions of movement in the case of thermal expansion. At this point, the elastically deformable portions 430 contract in the longitudinal direction because the second connecting portions 420 of the adapters 400 are securely held between the clamp pieces 122 and the wall surfaces 111a1 of the adapter containing recesses 111a of the connecting devices 100. This contraction of the elastically deformable portions 430 reduces the load applied to the lead terminals 12 and to the portions proximal to the lead terminals 12 of the lamp portions 11 during thermal contraction of the cold cathode fluorescent lamp 10.

A description is given below of the maintenance procedure of the present connection structure.

For replacing any one of the cold cathode fluorescent lamps 10 or any one of the adapters 400, the cold cathode fluorescent lamp 10 is lifted up, away from the connecting device 100. Then, the adapters 400 connected to the ends of the cold cathode fluorescent lamp 10 are released from grip between the leading ends of the clamp pieces 122 of the connecting devices 100 connected to the ends in the Y direction of the circuit board 300 and the wall surfaces 111a1 of the adapter receiving recesses 111a in the connecting devices 100. The adapters 400 can thus be taken out of the adapter receiving recesses 111a of the connecting devices 100. Now the faulty cold cathode fluorescent lamp 10 or adapter 400 can be removed and replaced.

For replacing the circuit board 300 or any one of the connecting devices 100, the circuit board 300 is moved in the X direction. Then, the pairs of locking pieces 114 of the connecting devices 100 installed on the end portions of the frame 200 are slid from the narrower holes 312 to the wider holes 311 of the pairs of locking holes 310. The hooks 114a of the pairs of locking pieces 114 are thereby set free from the engagement with the lips 312a of the narrower holes 312.

The circuit board 300 is then moved downward, i.e., in the Z direction away from the frame 200, to take out the locking pieces 114 of the connecting devices 100 from the wider holes 311 of the pairs of locking holes 310. In this manner, all the connecting devices 100 mounted on the end portions of the frame 200 are thus detached from the circuit board 300 at a stroke, i.e., in a single operation.

A possible concern is that the cold cathode fluorescent lamps 10 may be shaken and damaged during the detachment of the circuit board 300 from the connecting devices 100 with the cold cathode fluorescent lamps 10 connected to the connecting devices 10 via the adapters 400. The shakes of the lamps 10 are actually absorbed by the elastically deformable portions 430 being elastically deformed in the X, Y, and/or Z directions. It is hence possible to reduce the load due to the shakes applied to the lead terminals 12 and to the portions proximal to the lead terminals 12 of the lamp portions 11 of the cold cathode fluorescent lamps 10.

Thereafter, the detached circuit board 300 is replaced with a new one. Alternatively to replace one of the connecting devices 100, the connecting device 100 should further be pressed downward i.e., in the Z direction away from the frame 200, after the detachment of the cold cathode fluorescent lamps 10 and the adapters 400 in a manner as described above. Then, the lips 211 of the associated locating hole 210 in the frame 200 slide over the pair of locking projections 112 of the connecting device 100. The faulty connecting device 100 is thereby removed from the frame 200 for replacement.

After the replacement, all the connecting devices 100 are re-attached to the circuit board 300 by reversing the detachment steps, with the cold cathode fluorescent lamp 10 connected thereto via adapters 400. At this time also, the cold cathode fluorescent lamp 10 is shaken, but the shake is absorbed by the elastically deformable portions 430 of the adapters 400 being elastically deformed in the X, Y, and/or Z directions.

In the above described connection structure of a circuit board and a connecting device, connection is advantageously simple. Particularly, simply by inserting the pair of locking pieces 114 of each connecting device 100 into the wider holes 311 of the pair of locking holes 310 in the circuit board 300, followed by sliding of the pair of locking pieces 114 from the wider holes 311 to the narrower holes 312, the pair of locking pieces 114 are locked at the lips 312a of the narrower holes 312, and the contacting portions 123 of the contact 12 of the connecting device 100 are brought into elastic contact with the associated contact conductor 320 on the circuit board 300. The plurality of connecting devices 100 can thus be easily connected to the circuit board 300 without the need of using a plurality of clips as in the conventional example. As a result, the structure is easy to assemble, and further, the structure has fewer components by the elimination of the clips. Hence, the connection structure can be assembled at a reduced cost in comparison with the conventional example. Moreover, the locking pieces 114 are lockingly engaged at the lips 312a of the narrower holes 312 and the contacting portions 123 of the contacts 120 elastically touch the contact conductors 320 on the circuit board 300. The structure of the embodiment can therefore maintain stable electrical connection between the connecting devices and the circuit board, in contrast to the conventional example which may suffer unstable connection due to decrease in holding strength of the clips.

The structure of the embodiment is also advantageous in ease of maintenance. Particularly, the connecting devices 100 can be detached from the circuit board 300 at a stroke just by moving the circuit board 300 in the X direction to slide the pairs of locking pieces 114 of the connecting devices 100 attached to the frame 200 from the narrower holes 312 to the wider holes 311 in the circuit board 300. Components are thus easily disassembled for repair and replacement work.

It also becomes possible to detach any one of the cold cathode fluorescent lamps 10 and/or any one of the adapters 400 from connecting devices 100 for replacement, simply by moving the cold cathode fluorescent lamp 10 in an upward direction. Ease of maintenance is enhanced also in this respect.

The above connection structure of a circuit board and a connecting device can be modified in design appropriately insofar as the change is within the scope of the claims. Detailed description of modifications is given below.

In place of the locking pieces 114 as employed in the foregoing embodiment, each connecting device 100 may be provided with locking holes 310. In this case, the locking pieces 114 should be provided on the circuit board 300. Further, each connecting device has two locking pieces 114 in the foregoing embodiment, but at least one locking piece will suffice. The same holds true for the locking hole 310 formed in the circuit board 300, i.e., each locking hole 310 may correspond to a single locking piece 114 of the associated connecting device 100. Similarly in the case where locking pieces 114 are formed in the circuit board 300, each locking piece 114 may correspond to a single locking hole 310 of the associated connecting device 100.

The locking pieces 114 of the above embodiment are of flat plate-like shape, but the present invention is not limited thereto. For example, the locking pieces 114 may be of bar-like shape. The locking pieces 114 of the above embodiment have the locking hooks 114a, but the present invention is not limited thereto.

The locking holes 310 should at least be formed as elongated holes and may be changed in design appropriately insofar as the locking pieces can slide or turn in the locking holes and become locked at their lips. A modification example is such that the width dimension of each locking hole 310 is gradually reduced from the wider hole 311 toward the narrower hole 312, and that each locking piece 114 is press fitted into the narrower hole 312 so as to be locked between two lateral lips 312a of the narrower hole 312.

The retaining part of the foregoing embodiment consists of the locking projections 112 and the flange 113, but the present invention is not limited thereto. For example, the retaining part may consist of a piece member/members provided at the body 110 and a hole/holes, for engagement with the piece member/members, provided in a lip/lips 211 of a locating hole 210 in a frame 200.

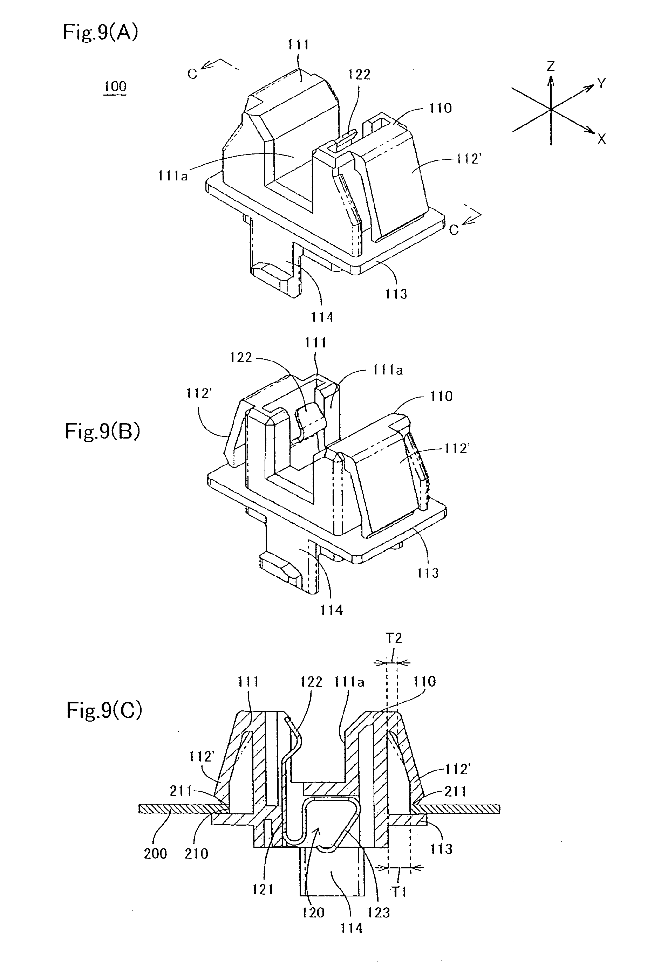

Each connecting device 100 may be provided with a pair of locking arms 112', in place of the pair of locking projections 112, on opposite outer faces in the X direction of the body 110. As shown in Figs. 9A to 9C, the locking arms 112' may have proximal ends connected to the outer faces of the connecting device 100 and leading ends that face the flange 113 with a clearance therebetween. Each locking arm 112' may extend at a slant such that its leading end is separated from the associated outer face of the body 110 by a distance T1 that is greater than the distance T2 between the proximal end and the outer face.

In the modified connecting device 100 as shown in Figs. 9A to 9C, upon insertion of the connecting device 100 into a locating hole 210 in a frame 200, the locking arms 112' are pressed by lips 211 of the locating hole 210 and thereby deformed elastically toward the outer faces of the body 110. When the lips 211 of the locating hole 210 pass or climb over the leading ends of the locking arms 112', the locking arms 112' are restored to the original position. As shown in Fig. 9C, the lips 211 of the locating hole 210 are thus lockingly engaged between the leading ends of the locking arms 112' and the flange 113. As such, the modified connecting device is also easy to attach to the frame 200.

The detachment of the modified connecting device 100 from the frame 200 is also easy. More particularly, the locking arms 112' are pressed toward the outer faces of the body 110 to be elastically deformed, releasing the lips 211 of the locating hole 210 from the engagement in between the leading ends of the locking arms 112' and the flange 113. With the locking arms 112' pressed, the frame 200 can be moved, in relation to the connecting devices, to the side of the locking arms 112'.

The locking projections 112 of the above embodiment are of tapered shape in which the upper and lower ends have thicknesses reduced gradually in directions away from each other, but the present invention is not limited thereto. More specifically, the locking projections 112 may be changed in design appropriately insofar as the locking projections 112 are in the form of a projection that is capable of locking a frame 200.

The flanges 113 may be modified in design appropriately insofar as they are adapted to abut on the lips 211 of the locating holes 210 in the frame 200 and lock the lips 211 between the locking projections and themselves.

The contacts 120 may be modified in design appropriately insofar as the contacts 120 are adapted to connect to the lead terminals 12 of the cold cathode fluorescent lamps 10, directly or indirectly via the adapters 400.

In the foregoing embodiment, the clamp pieces 122 of the contacts 120 are electrically and mechanically connected to the ends of the cold cathode fluorescent lamps 10 via the adapters 400 by securely holding the second connecting portions 420 of the adapters 400 between the clamp pieces 122 themselves and the wall surfaces of the adapter containing recesses 111a in the bodies 110; however, the clamp pieces 122 may be modified in design appropriately insofar as the clamp pieces 122 serve as a connecting portion that is adapted to be connected directly to or indirectly via the adapter 400 to an end of an electronic component such as a cold cathode fluorescent lamp 10. For example, the connecting portion may be a generally U-shaped connecting piece or a pair of clamp pieces for fitting a lead terminal 12 or the first connecting portion 410 of an adapter 400 therein.

The contacting portions 123 of each contact 120 of the foregoing embodiment form a pair of bent or meandering arms that elastically touch contact conductors 320 on the circuit board 300. The contacting portions 123 may be modified in design appropriately insofar as the contacting portions 123 constitute a connecting portion that is adapted to connect directly or indirectly to a contact conductor 320 on a circuit board 300. For example, the connecting portion may be a generally L-shaped piece member to be soldered to a contact conductor 320 on a circuit board 300 or a crimp portion to be crimped with a lead wire etc. for electrical connection to a circuit board 300.

The adapters 400 may be modified in design appropriately insofar as each has a first end to be electrically and mechanically connected to an end of an electronic component such as a cold cathode fluorescent lamp 10, a second end to be electrically and mechanically connected to a connecting device, and an elastically deformable portion provided between the first and second ends and elastically deformable at least in a longitudinal direction of the electronic component.

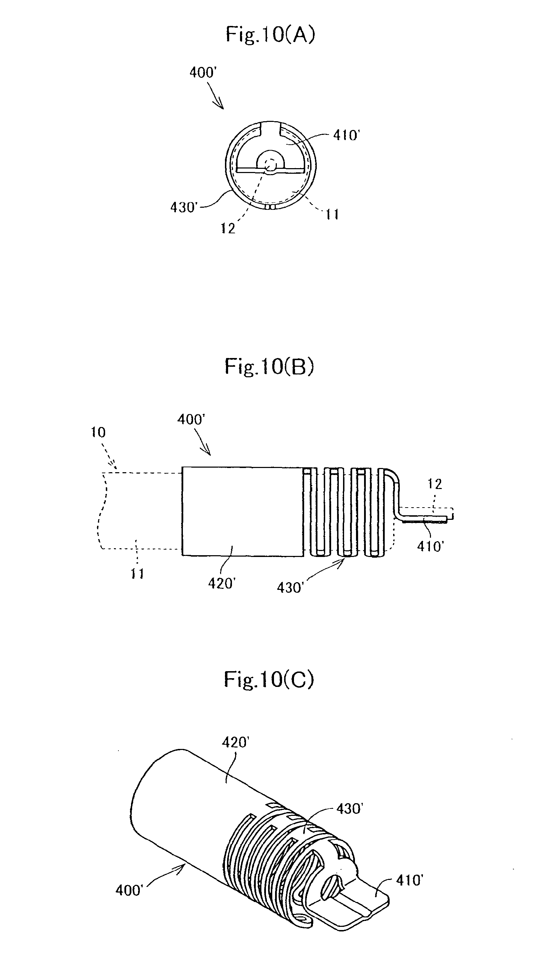

As such, the adapters 400 may not be coil springs as described above. For example, a conductive plate may be pressed into an adapter 400' as shown in Figs. 10A to 10C. The adapter 400' has a first connecting portion 410' that is a plate body of L-shape in cross section, a second connecting portion 420' that is a cylindrical plate body, and an elastically deformable portion 430' that is provided between the first and second connecting portions 410' and 420'.

This modified first connecting portion 410' has a through hole that allows a lead terminal 12 to pass therethrough. The elastically deformable portion 430' is a plate body having a cylindrical shape partially cut out and is elastically deformable in a longitudinal direction of a cold cathode fluorescent lamp 10 in the same manner as the elastically deformable portions 430.

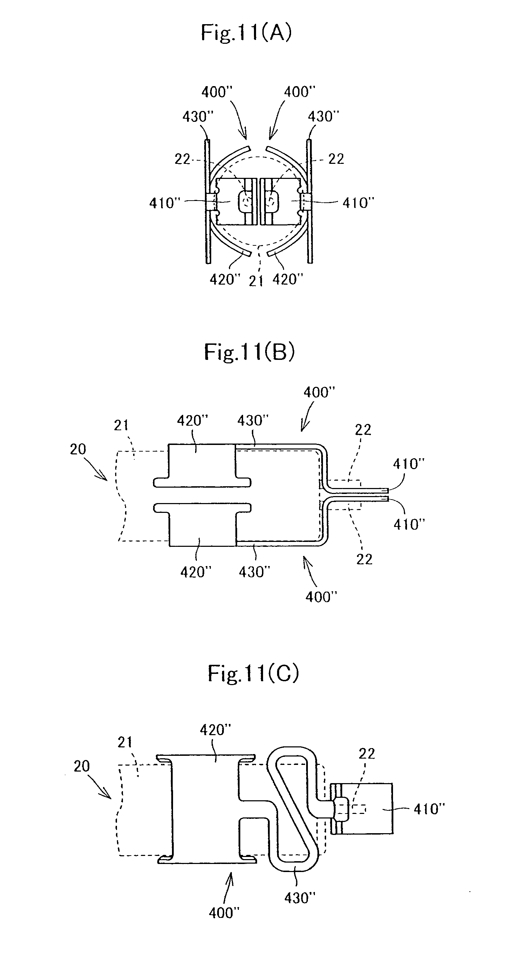

Figs. 11A to 11C illustrate a case where the electronic components are not the cold cathode fluorescent lamps 10 but hot cathode fluorescent lamps 20 with lamp parts 21, each hot cathode fluorescent lamp 20 being attached to two adapters 400". The adapters 400" may be fabricated by press forming from a conductive plate. The adapters 400" each have a first connecting portion 410" that is a plate body of L-shape in plan view, a second connecting portion 420" that is a plate body of a semi-circular arc shape in cross sectional view, and an elastically deformable portion 430" of a generally S-shape in side view that is provided between the first and second connecting portions 410" and 420".

This modified first connecting portion 410" has a through hole for receiving therethrough one of the lead terminals 22 of a hot cathode fluorescent lamp 20. The elastically deformable portion 430" is elastically deformable in a longitudinal direction of the hot cathode fluorescent lamp 20 in the same manner as the elastically deformable portions 430.

Note that the adapters 400, 400', and 400" may be omitted in the case where the electronic components such as cold cathode fluorescent lamps 10 are directly connected to the connecting devices 100.

The frame 200 may be modified in design appropriately insofar as it serves as a locating and holding means that functions to align and hold the connecting devices 100 in a direction orthogonal to the longitudinal direction of electronic components such as cold cathode fluorescent lamps 10. For example, the locating and holding means may be a plate with a plurality of projections along their ends. The projections are used to fit into holes in connecting devices so as to align and hold the connecting devices in the direction perpendicular to the longitudinal direction of the electronic components. Alternatively, the locating and holding means may be a plate with a plurality of holes along their ends, which holes can be used to mate with projections provided on connecting devices so as to align and hold the connecting devices in the direction perpendicular to the longitudinal direction of the electronic components. Still alternatively, the locating and holding means may be a plate with recesses along their ends for mating with the connecting devices.

If the above holes and projections are employed, the locking projections 112 and the flanges 133 can be omitted.

The frame 200 of the above embodiment has the locating holes 210 along their both ends in the Y direction, but the present invention is not limited thereto. A modification example is to provide two frames 200, each of which has a line of locating holes 210 opened centrally along the X direction. In this case, connecting devices to be connected to first ends of cold cathode fluorescent lamps 10 are located and held in the locating holes 210 in one of the frames 200, while connecting devices to be connected to second ends of the cold cathode fluorescent lamps 10 are located and held in the locating holes 210 in the other frame 200. In this case also, the abovementioned projections, holes, and recesses may be used in place of the locating holes 210 as has been described earlier. The frame/frames 200 (locating and holding means) may be employed in the case of connecting electronic components directly to connecting devices 100 without using adapters 400.

The frame 200 may be omitted. If so, the locking projections 112 and the flanges 113 may also be omitted.

The circuit board 300 has been described as a printed circuit board. However, the circuit board 200 should at least be a plate member for fixing connecting devices, without electrical circuitry for connection with electronic components. A circuit board is defined herein as a plate of any kind, including a plate with no electronic circuit formed thereon.

The above embodiment has been described as a connection structure of a circuit board 300 and connecting devices 100 that are sockets connectable with cold cathode fluorescent lamps 10. The connection structure of the invention is also applicable as a connection structure of a circuit board and connecting devices such as connectors connectable with electronic components. The electronic components used include not only illumination lights such as the cold cathode fluorescent lamps 10 or the hot cathode fluorescent lamps 20 described above, but also include other kinds of electronic components such as plugs and cables connectable with connectors. Note that the shape and arrangement of each component may be modified in design appropriately insofar as the components implement the same functions as described above.

### Reference Signs List

10 cold cathode fluorescent lamp (electronic component)
20 hot cathode fluorescent lamp (electronic component)
100 connecting device
   110 body
      112 locking projection
      113 flange
      114 locking piece
   120 contact
      123 contacting portion
200 frame (locating and holding means)
   210 locating hole
300 circuit board
   310 locking hole
      311 wider hole
      312 narrower hole
400 adapter
   410 first connecting portion
   420 second connecting portion
   430 third connecting portion

## Claims

1. A connection structure of a circuit board and a connecting device, the connection structure comprising:
a connecting device (100) electrically and mechanically connectable to an electronic component (10, 20); and
a circuit board (300) having a surface for mounting the connecting device thereon,
the connecting device including a locking piece (114) for attaching the connecting device to the surface of the circuit board,
the circuit board including an elongated locking hole (310) for receiving the locking piece,
wherein the locking piece is adapted to be locked at a lip (312a) of the locking hole by sliding or turning the locking piece in a predetermined direction inside the locking hole.

2. A connection structure of a circuit board and a connecting device, the connection structure comprising:
a connecting device (100) electrically and mechanically connectable to an electronic component (10, 20); and
a circuit board (300) having a surface for mounting the connecting device thereon,
the circuit board including a locking piece for attaching the connecting device to the surface of the circuit board,
the connecting device including an elongated locking hole for receiving the locking piece,
wherein the locking piece is adapted to be locked at a lip of the locking hole by sliding or turning the locking piece in a predetermined direction inside the locking hole.

3. The connection structure according to claim 1 or 2, wherein
the locking hole (310) has a wider hole (311) and a narrower hole (312) continuous with the wider hole, and
the locking piece (114) is adapted to be locked at the lip (312a) of the locking hole by inserting the locking piece into the wider hole and sliding the locking piece from the wider hole to the narrower hole.

4. The connection structure according to claim 1 or 2, wherein the connecting device comprises a plurality of connecting devices (100) that are aligned and held on the surface of the circuit board (300), the connection structure further comprising:
a locating and holding means (200) for locating and holding the connecting devices in attachment to and detachment from the circuit board, in such a manner as to correspond to an arrangement of the connecting devices on the circuit board.

5. The connection structure according to claim 4, the connecting devices comprising a first set of connecting devices (100) that are electrically and mechanically connectable to respective first ends in a longitudinal direction of a plurality of electronic components (10, 20) and a second set of connecting devices (100) that are electrically and mechanically connectable to respective second ends in the longitudinal direction of the electronic components, wherein
the locating and holding means (200) is configured to locate and hold the first and second sets of connecting devices to be aligned in a direction orthogonal to the longitudinal direction.

6. The connection structure according to any one of claims 1, 2 and 3, further comprising an adapter (400) interposed between the connecting device (100) and an electronic component (10, 20) inserted, in use, in the connecting device,
the adapter including:
a first end portion (410), electrically and mechanically connectable to an end of the inserted electronic component;
a second end portion (420), electrically and mechanically connectable to the connecting device; and
an elastically deformable portion (430), provided between the first and second ends and elastically deformable at least in the longitudinal direction of the electronic component.

7. The connection structure according to claim 4 or 5, further comprising adapters (400) interposed between the connecting devices (100) and electronic components (10, 20) inserted, in use, in the connecting devices,
the adapters each including:
a first end portion (410), electrically and mechanically connectable to an end of an inserted electronic component;
a second end portion (420), electrically and mechanically connectable to an connecting device; and
an elastically deformable portion (430), provided between the first and second ends and elastically deformable at least in the longitudinal direction of the electronic component.

8. The connection structure according to claim 6,
wherein the elastically deformable portion (430) is configured to absorb impact on the electronic component (10, 20) while the connecting device (100) is being attached to or detached from the circuit board (300) with the electronic component connected to the connecting device via the adapter (400).

9. The connection structure according to claim 7,
wherein the elastically deformable portions (430) are configured to absorb impact on the electronic components (10, 20) while the connecting devices (100) are being attached to or detached from the circuit board (300) with the electronic components connected to the connecting devices via the adapters (400).

10. The connection structure according to claim 1 or 2, wherein
the connecting device (100) includes:
a body (110) provided with the locking piece (114) or the locking hole; and
a contact (120) received in the body, the contact having a contacting portion (123) projecting from the body toward the circuit board (300),
the connection structure being configured such that the contacting portion touches a contact conductor (320) on the surface of the circuit board when the locking piece (114) is brought into engagement with the lip (312a) of the locking hole (310).

11. The connection structure according to claim 4 or 5, wherein
the locating and holding means (200) is an elongated member that faces the circuit board (300) and includes locating holes (210) to receive the connecting devices (100), and
the connecting devices each further include a retaining part (112, 113) for preventing the connecting device from falling off from the associated locating hole in the locating and holding means.

12. The connection structure according to claim 11, wherein
the retaining parts each include a flange (113) and a locking formation (112, 112'), the flange projecting from an outer surface of each connecting device (100), the locking formation being provided on the outer surface of the connecting device, the flange and the locking formation being spaced apart from each other in an insertion direction of the connecting device, and
the connection structure is configured such that, upon insertion of each connecting device into the associated locating hole (210), the lip (211) of the locating hole in the locating and holding means passes over the locking formation and is locked between the locking formation and the flange.

13. The connection structure according to claim 12, wherein
the locking formation is a locking projection (112) having two ends in the insertion direction, the two ends being tapered such that a thickness of the locking projection gradually reduces in directions away from each other.

14. The connection structure according to claim 12, wherein
the locking formation is a locking arm (112'), the locking arm having a proximal end and a leading end, the proximal end being connected to the outer surface of the connecting device (100) and the leading end facing the flange (113) with a gap therebetween,
each locking arm is configured such that a distance between the leading end and the outer surface of the connecting device is greater than a distance between the proximal end and the outer surface of the connecting device,
when each connecting device is inserted in the associated locating hole (210), the associated locking arm is pressed against the lip (211) of the locating hole and is elastically deformed toward the outer surface of the connecting device, and
when the lip of the locating hole moves over the leading end of the locking arm, the locking arm is restored and the lip of the locating hole is thereby locked between the leading end of the locking arm and the flange.

15. The connection structure according to claim 11, the electronic components (10, 20) comprising illumination lights, wherein
the locating and holding means (200) also functions as a reflector board for reflecting light flux emitted from the illumination lights.
